# EUROPÄISCHE PATENTSCHRIFT

(11) **EP 2 633 095 B1**
(45) Veröffentlichungstag und Bekanntmachung des Hinweises auf die Patenterteilung: **13.09.2017**
(21) Anmeldenummer: 11779086.5
(22) Anmeldetag: 06.10.2011
(51) Int. Cl.: C23C 28/00, C23C 28/04, C23C 14/00, C23C 14/02, C23C 14/08, C23C 14/06, C23C 14/32, C23C 14/54, C23C 14/34

(54) **MOLYBDÄNMONOXIDSCHICHTEN UND DEREN HERSTELLUNG MITTELS PVD**
MOLYBDENUM MONOXIDE LAYERS, AND PRODUCTION THEREOF USING PVD
COUCHES DE MONOXYDE DE MOLYBDÈNE ET OBTENTION DESDITES COUCHES DE MONOXYDE DE MOLYBDÈNE PAR PVD

(30) Priorität: 08.12.2010 DE 102010053751; 28.10.2010 US 407656 P
(43) Veröffentlichungstag der Anmeldung: 04.09.2013
(73) Patentinhaber: Oerlikon Surface Solutions AG, Pfäffikon, 8808 Pfäffikon (CH)
(72) Erfinder: RAMM, Jürgen, CH-7304 Maienfeld (CH); WIDRIG, Beno, CH-7310 Bad Ragaz (CH); GLÄNTZ, Kerstin, CH-9403 Goldach (CH); SEIBERT, Florian, CH-9475 Sevelen (CH)
(74) Vertreter: Kempkens, Anke
(86) Internationale Anmeldenummer: PCT/EP2011/004990
(87) Internationale Veröffentlichungsnummer: WO 2012/055485

(56) Entgegenhaltungen:
- EP-A1- 1 146 140
- WO-A1-2010/020362
- DE-A1-102006 036 101
- US-A1- 2006 042 728
- US-A1- 2007 003 693
- US-A1- 2009 256 215
- US-A1- 2009 269 600
- US-A1- 2010 167 463
- SUSZKO T ET AL: "The role of surface oxidation in friction processes on molybdenum nitride thin films", SURFACE AND COATINGS TECHNOLOGY, ELSEVIER, AMSTERDAM, NL, Bd. 194, Nr. 2-3, 1. Mai 2005 (2005-05-01) , Seiten 319-324, XP027609252, ISSN: 0257-8972 [gefunden am 2005-05-01]

## Beschreibung

Die Erfindung bezieht sich auf die Beschichtung von Komponenten und Werkzeugen, die gute Gleiteigenschaften aufweisen sollen, oder in tribologischen Systemen eingesetzt werden, bei denen in der Regel Schmierstoffe zur Reibminderung verwendet werden müssen.

Weiterhin bezieht sich die Erfindung auf eine Beschichtung von Komponenten oder Werkzeugen, bei denen die Gefahr besteht, dass es während des Kontaktes mit dem Gegenkörper oder mit dem zu bearbeitendem Werkstoff zu Aufschmierungen kommt. Beispiele dieser Komponenten sind Kolbenringe, Kolbenoberflächen, Einspritzdüsen, Gleitlager, Dichtringe im Motorenbereich sowie im Allgemeinen Gleitelemente und Getriebeelemente. Ebenfalls sind Beispiele dieser Werkzeuge Umformwerkzeuge wie Presswerkzeuge für die Aluminiumverarbeitung oder Kunststoffverarbeitung und ebenso Zerspanungswerkzeuge wie Bohrer, Fräser und Wendeschneidplatten für die Zerspanung von Aluminium, Stählen und verschiedenen Metalllegierungen sowie im Allgemeinen Form- und Schneidwerkzeuge.

### Stand der Technik

Aufgrund der bewiesenen guten Eigenschaften seiner Verbindungen insbesondere mit Sauerstoff und Stickstoff stellt sich Molybdän als ein sehr interessantes Element zur Erzeugung von verschiedenen Verbundwerkstoffen, die als z.B. Verschleissschutzschichten oder Festschmierstoffen angewendet werden können.

So ist zum Beispiel bekannt, dass die Präsenz von Molybdäntrioxid (MoO₃) als Zwischenstoff, d.h. ein zwischen zwei aneinander reibenden Körpern vorgesehenes Material (ein solcher Zwischenstoff wird üblicherweise als Schmiermittel vorgesehen) in tribologischen Systemen, vorteilhaft wirken kann, weil sie eine verschleissmindernde Absenkung der tribologischen Belastung bewirkt (siehe zum Beispiel DE102006036101 A1).

Allerdings gestaltet sich bisher die Herstellung von Molybdänoxidschichten in wirtschaftlichem Umfang als schwierig. Insbesondere die Herstellung von Molybdänoxid-Verschleissschutzschichten mittels Dünnschichttechnologie.

In DE102006036101 A1 wurde von z.B. einem Beschichtungsverfahren, insbesondere für Ventilelemente angegeben, das eine dauerhafte Einbringung eines Festschmierstoffes auf der Basis von Molybdän ermöglichte, berichtet. Hierzu wurde im Rahmen eines Lichtbogen-Schweissprozesses Molybdänpartikel in die Schweissnaht eingebettet. In der Anwendung als Ventilelement hat sich dann, so vermuten die Autoren der DE102006036101 A1, durch Nachoxidation Molybdäntrioxid (MoO₃) gebildet, wobei die Schmiereigenschaften sogar noch verbessert wurden.

In US20090256215 wurde von einigen Methoden zur Erzeugung von dünnen Molybdänoxidschichten (MoOₓ) Schichten zur Herstellung von Gassensoren, insbesondere von Brandmeldern auf Basis von Kohlenstoffmonoxid (CO) berichtet. Gemäss den beschriebenen Methoden wird zuerst der Gegenstand zweckmässig maskiert und mit einer 45 bis 150 Å dicken Mo-Schicht mittels eines Elektronenstrahl-Verfahrens beschichtet. Anschliessend wird der Mo-beschichteten Gegenstand in Luft- oder kontrollierter Atmosphäre während mehrerer Tage angelassen, um das Wachstum vom MoOₓ zu ermöglichen. Die Autoren haben über besondere Vorteile beim Wachstum der von ihnen gewünschten Molybdänoxid Phase (die Kohlenstoffmonoxid-selektive Phase β-MoO_{3-δ}) berichtet, wenn das Anlassen (annealing) in einer O₂ Atmosphäre bei einem Druck von 1.2 - 1.6 atm und bei einer Temperatur von 175 - 225 °C während 2 - 6 Stunden stattfindet. Die Autoren haben auch nebenbei erwähnt, dass früher zu dem gleichen Zweck dünne Molybdäntrioxidschichten (MoO₃) mit Dicken von 200 bis 400 nm mittels Sol-Gel und und RF Magnetron Sputtering Prozessen hergestellt wurden.

In Surface and Coatings Technology 163-164 (2003) 413-421 wurde über Cr₂O₃/MoO₃-Schichten, die durch die Verwendung von Pulvermischungen aus Cr₂O₃ und MoO₃ mittels thermischen Spritzens hergestellt wurden, berichtet. Gemäss den Autoren des Artikels zeigten diese Schichten eine verbesserte Reibminderung im Vergleich zu ähnlich hergestellten Cr₂O₃-Schichten aber ohne MoO₃.

Im Gegensatz zu den Molybdänoxidschichten ist für Molybdännitridschichten die Herstellung und Anwendung als Verschleissschutzschichten besser erforscht.

In Journal of Materials Science Letters 5 (1986) 255-256) haben die Autoren z.B. über die Herstellung von Molybdännitridschichten mittels Plasma thermisches Spritzen berichtet. Die Autoren kommentierten auch nebenbei, dass die untersuchten Herstellungsprozesse kleinen Mengen vom Molybdändioxid (MoO₂) als Nebenprodukt erzeugt wurden. Allerdings muss man berücksichtigen, dass MoO₂ eine tetragonale oder monokline Struktur aufweist und ist dementsprechend sehr abrasiv und somit nicht für Reibminderung geeignet (siehe z. B. Surface and Coatings Technology 163-164 (2003) 413-421).

Weitere bekannte Beschichtungstechnologien zur Herstellung von Molybdännitridschichten, die zum Beispiel in Surface and Coating Technology 167 (2003) 77-82) erwähnt werden, sind:
- Ionenstrahl unterstützten Prozessen
- physikalische Dampfablagerungsprozesse bzw. PVD-Prozessen wie z.B. Sputter- und Funkenverdampfung
- Stickstoff Ionenimplantation in bereits mit Molybdän beschichteten Oberflächen

Auch in der oben genannten Publikation werden verschiedene Forschungsarbeiten über Diffusionsbarriere-, Supraleiter-, katalytische und tribologische Eigenschaften von Molybdännitridschichten zitiert. Daraus lässt sich folgern, dass Molybdännitrid abhängig von der realisierten Struktur bestimmte physikalische, chemische und elektrische Eigenschaften aufweisen kann und dadurch kann Molybdännitrid in vielfältigen Anwendungen gut geeignet sein.

Untersuchungen von der Phasenzusammensetzung in mittels Funkenverdampfung hergestellten Mo-N Schichten wurden in Surface and Coating Technology 167 (2003) 77-82. Dabei wurde festgestellt, dass die Phasen in mittels Funkenverdampfung hergestellten Mo-N Schichtsystemen durch die Variation von Stickstoffdruck, Substratbias und Substrattemperatur gezielt eingestellt werden können.

In DE19944977 B4 wurde ein Verfahren zur Steigerung der Grenzschmierung von niedrig legiertem Stahl mit geschmierten Kontakten in einem Brennstoffeinspritzsystem beschrieben. Das Verfahren weist die Schritte auf, ein niedrig legiertes Stahlsubstrat vorzubereiten und dann eine Metallnitridbeschichtung oder eine diamantartige Kohlenstoffbeschichtung auf dem niedrig legiertem Stahlsubstrat zu bilden, und zwar unter Verwendung eines physikalischen Dampfablagerungsprozesses bzw. eines PVD-Prozesses bei niedriger Temperatur. Die Autoren schreiben auch, dass diese Beschichtungen von Brennstoffsystemkomponenten dahingehend arbeiten, dass sie die Schmierfähigkeit von gewissen Brennstoffen mit niedriger Schmierfähigkeit verbessern und somit die Notwendigkeit für Hilfsschmiermittel für die Brennstoffzusammensetzungen mit niedriger Schmierfähigkeit verringern oder minimieren kann. Im Sinne vom oben beschriebenen Verfahren erwähnten die Autoren unter anderen Nitriden das Molybdännitrid als ein geeignetes Nitrid für die Beschichtung.

In Surface and Coatings Technology 174-175 (2003) 713-719) wird berichtet, dass wenn PVD-hergestellte Molybdännitridschichten bei tribologischen Anwendungen eingesetzt werden und dadurch aufgrund der Reibung unter oxidativen Bedingungen bei hohen Temperaturen stehen, die Molybdännitridschichten oxidieren. Die Autoren weisen weiterhin aus, dass wenn die Molybdännitridschichten oxidieren, die Eigenschaften der oxidierten Schichtoberflächen fangen an die Reibungs- und Verschleissmechanismen zu dominieren.

Auch durch die Beschichtung mit Molybdännitrid ist es möglich gute Gleiteigenschaften aufzuweisen wie in DE29620687 U1 offenbart ist. In diesem Dokument wird ein Prozess zur Herstellung einer Beschichtung für chirurgische Instrumente aus Stahl beschrieben. Zur Herstellung der Beschichtung wird das chirurgische Instrument in eine Stickstoff-Atmosphäre gebracht. In dieser Stickstoff-Atmosphäre wird ein elektrischer Lichtbogen erzeugt, wozu Elektroden aus einer Nitridbildner enthaltenden Legierung verwendet werden. Die Elektroden verdampfen in dem Lichtbogen. Die verdampfenden Metallatome schlagen sich auf dem Stahl nieder, wobei sie sich mit dem Stickstoff verbinden. Die für die Elektroden verwendeten Legierungen enthalten vorzugsweise Titan und/oder Chrom sowie Aluminium. Vorzugsweise werden als metallische Nitridbildner Titan und/oder Chrom und/oder gegebenenfalls Molybdän verwendet. Hierzu kann vorzugsweise ein mehr oder weniger grosser Anteil an Aluminium zugegeben werden. Die Autoren berichten, dass die so hergestellte Beschichtung folgende vorteilhafte Eigenschaften aufweist:
- äusserst glatte Oberfläche und dadurch besonders gute Gleiteigenschaften bei Schneidinstrumenten
- hohe Härte und dadurch wird gegen mechanische Beschädigung widerstandfähig
- gute Verbindung zwischen der Beschichtung und dem Stahl durch das Eindiffundieren der Metalle und des Stickstoffs in die Oberfläche des Stahls beim Aufdampfen. Gemäss den Autoren Aluminium reagiert besonders gut mit Stickstoff, so dass sich auch ein Eindiffundieren von Stickstoffatomen in die Stahl-Oberfläche ergibt und dies zu einer guten Verbindung zwischen der Beschichtung und der Stahl-Oberfläche führt, was demzufolge zu einem zusätzlichen Härten der Stahl-Oberfläche führt.
- hohe Korrosionsfestigkeit, die gemäss den Autoren insbesondere Titan und Chrom in Schicht bewirken.

In SU1832751A1 wird offenbart, dass wenn unzureichende Schichthaftung von Molybdännitrid (Mo-N) Schichten zum Substrat vorkommt, entsprechende Substratsvorbehandlungen zur Verbesserung der Schichthaftung durchgeführt werden können.

In JP2006255708 berichtet Ishikawa über abrasionsbeständige Beschichtungen, die unter anderem folgende Komponenten enthalten:
- mindestens 15 Atomprozent Silizium (von den metallischen Komponenten)
- zwischen 5 und 85 Atomprozent Molybdän (von den metallischen Komponenten)
- mindestens 10 Atomprozent Stickstoff (von den nicht metallischen Komponenten)
- zwischen 0.1 und 10 Atomprozent Sauerstoff (von den nicht metallischen Komponenten)

Weiter bekannt sind die folgenden Anwendungen und Herstellungsprozesse von Mo-haltigen, insbesondere MoN- und Molybdänoxidhaltigen Beschichtungen:
- Brennstoffeinspritzvorrichtung mit Beschichtung aus MoN (DE19944977B4)
- Einspritzsystem mit Beschichtung aus MoN, die mittels PVD-Techniken unter 200°C aufgebracht wurde (US2010078314 A1)
- Zylinderbüchse mit thermischen gespritzten Beschichtungen, die Mo und Molybdänoxid aufweisen (WO9521994 A1)

Sehr interessant zu berücksichtigen ist der Nachoxidationseffekt, über den in EP1783244 ausgewiesen wird. Yamamoto et al berichten in diesem Dokument über Hartstoffbeschichtungen für Zerspanungs- und Umformwerkzeugen, die mindestens eine Nitrid- oder Nitridkarbidschicht umfassen, die Molybdän oder Wolfram enthalten und mittels Sputter- und/oder Arc-Techniken abgeschieden werden, deren Oberflächen vermutlich bei Temperaturen nahe der bei gleitenden Oberflächen auftretenden Temperaturen nachoxidieren. Yamamoto et al erwähnen hier MoO₂ und MoO₃ als Produkte der Nachoxidation von den Mo-N Schichten.

Dieser Nachoxidationseffekt, bringt aber die folgenden Nachteile mit sich.
- Einerseits ist zu beachten, dass die Nachoxidation unkontrolliert auftritt, was die Erzeugung von sowohl MoO₃ als auch MoO₂ verursacht. Wie oben bereits erwähnt, MoO₂ weist abrasive Eigenschaften auf, die im Zusammenhang mit zum Beispiel benötigten guten Gleiteigenschaften sehr nachteilig sind.
- Während Anwendungen von Mo-N Schichten mit hoher mechanischer Beanspruchung sind andererseits sowohl die Reaktion (Nachoxidation von Mo-N) als auch die Gleiteigenschaften von Mo-N in Kombination mit den erwarteten Schmierungseigenschaften von MoO₃ nicht stabil, weil die während der Anwendung produzierten -Oxidverbindungen, insbesondere MoO₃-Partikel, sich kontinuierlich von der Mo-N Schicht lösen. Das führt rasch zu einer weiteren Oxidation der Mo-N Schichtoberfläche und bei fortschreitendem Prozess zu einem Abbau der Mo-N Schicht.

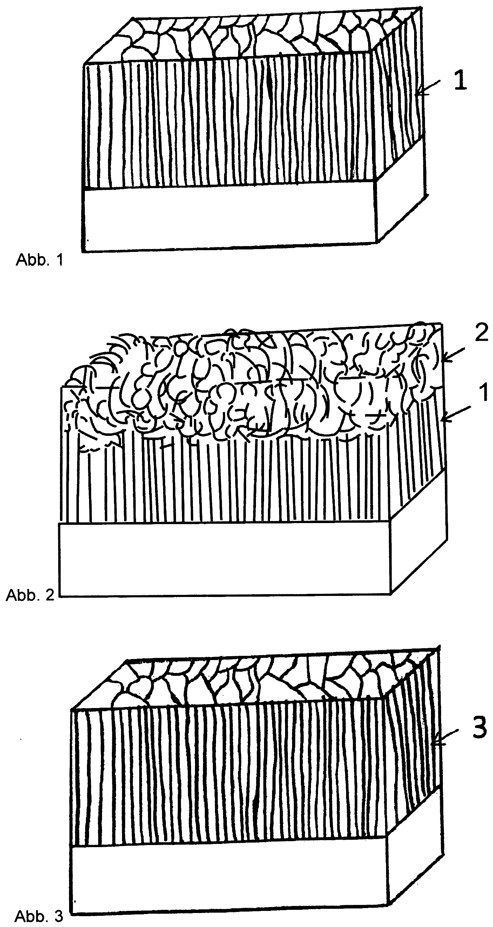

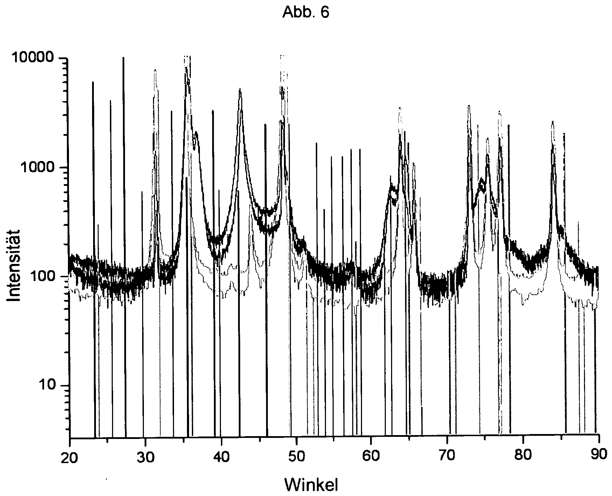

US2010/0167463 offenbart in Abbildung 3B eine MoOx-Schicht (32), wobei x ein positiver Zahl, wie 1 ist, darunter liegt eine MoN-Schicht (31A). PVD wird verwendet. In Abbildung 6B ist eine MoON-Schicht (62) offenbart.

### Aufgabe der Erfindung

Der vorliegenden Erfindung liegt die Aufgabe zugrunde, eine verbesserte Schicht und deren Herstellung anzugeben, die neben weiteren guten tribologischen Eigenschaften und/oder elektrischen Eigenschaften insbesondere auch gute und stabile Schmierstoffeigenschaften und/oder verbesserte Geschmeidigkeit aufweisst und vorzugsweise auch noch die weiteren oben erwähnten Nachteile der bisher bekannten Schichten zumindest abmindert.

### Erfindungsgemässe Lösung der Aufgabe

Erfindungsgemäss wird die Aufgabe durch eine Beschichtung nach Anspruch 1 gelöst. Weiter wird ein kontrollierbarer PVD Prozess angegeben, der es ermöglicht, Sauerstoff gezielt mit Molybdän reagieren zu lassen, so dass eine stabile Molybdänoxidverbindung in der Schicht zur Bildung kommt.

Insbesondere wird weiter ein kontrollierbarer PVD Prozess angegeben, der es ermöglicht, Sauerstoff gezielt in das MoN einzubauen ohne dass es in der Schicht wesentlich zur Bildung von MoO₂ und/oder MoO₃-Verbindungen kommt. Optional kann mittels des Prozesses an der Oberfläche eine MoO₃-Schicht als Festschmierstoff abgeschieden werden können.

Ein Schichtsystem gemäss einer Variante, die mindestens eine der folgenden zwei Schichten mit einer Sauerstoffkonzentration ≥0.03 umfasst umfasst, bevorzugt mindestens die zwei folgenden Schichten umfasst:
- Eine erste Schicht, die insbesondere sehr gute mechanische Stabilität aufweist und (Mo₁₋ₓ,Meₓ)AₐB_{b}C_{c}, enthält, wobei 0 ≤ x ≤ 0.99, vorzugsweise 0 ≤ x ≤ 0.5 und Me ein Metal aus der Gruppe von W, Ti, Al, Cr, Si, Zr, Ta, Nb, Ag, Cu und V ist, oder der Kombination aus zwei oder mehreren Metallen dieser Gruppe und
   A: Stickstoff (N) ist mit 0.5 ≤ a ≤ 1
   B: Kohlenstoff (C) ist mit 0 ≤ b ≤ 0.5
   C: Sauerstoff (O) ist mit 0 ≤ c ≤ 0.5
   und mit a, b, und c in at% zwischen den Elementen N, C und O angibt mit a+b+c = 1 und zusätzliche weitere Elemente vorgesehen sein können, aber vorzugsweise nicht vorgesehen sind.
- Eine zweite Schicht, die insbesondere sehr gute Schmierstoffeigenschaften und Gleiteigenschaften aufweist:
   (Mo_{1-y},Me_{y})AᵤBᵥC_{w}, enthält, wobei 0 ≤ y ≤ 0.99, vorzugsweise 0 ≤ y ≤ 0.5 und Me ein Metal aus der Gruppe von W, Ti, Al, Cr, Si, Zr, Ta, Nb, Ag, Cu und V ist, oder der Kombination aus zwei oder mehreren Metallen dieser Gruppe und
      A: Stickstoff ist mit 0 ≤ u ≤ 0.5
      B: Kohlenstoff ist mit 0 ≤ v ≤ 0.5
      C: Sauerstoff ist mit 0.5 ≤ w ≤ 1
   und mit u, v, und w at% zwischen den Elementen N, C und O angeben mit u+v+w = 1 und zusätzliche weitere Elemente vorgesehen sein können, aber vorzugsweise nicht vorgesehen sind.

Zur Herstellung einer erfindungsgemässen Schicht wird bevorzugt unter Prozessbedingungen gearbeitet, für die während der Durchführung eines PVD-Verfahrens zur Erzeugung eines PVD-Schicht in einer Nicht-Reaktivgastatmosphäre oder in einer Reaktivgastatmosphäre (ohne Sauerstoffzugabe) allmählich das in die Kammer zugeführte Reaktivgas teilweise durch den Sauerstoff ersetzt wird und dadurch Molybdänmonoxid (MoO) in die Schicht gebildet wird. Das zur Erzeugung des Molybdänmonoxids (MoO) notwendige Molybdän in der Beschichtungskammer wird aus einem molybdänhaltigen Target zugeführt, das in einer PVD-Quelle, bevorzugt in einer Funkenverdampfungsquelle entsprechend eingebaut ist. Die PVD-Quelle mit dem molybdänhaltigen Target muss mindestens kurz vor der Zugabe von Sauerstoff in die Beschichtungskammer aktiviert werden.

Molybdänmonoxid (MoO) ist gegenüber Molybdändioxid (MoO₂) und Molybdäntrioxid (MoO₃) vorteilhaft indem:
- MoO im Gegenteil zum MoO₂ nicht abrasiv ist
- MoO ähnlich wie MoO₃ sehr gute Gleit- und Schmierstoffeigenschaften aufweist aber sich im Vergleich zum MoO₂ und MoO₃ als wesentlich stabiler erweist.
- MoO gegen Aufschmierung wirkt.

Bevorzugt wird insbesondere unter Prozessbedingungen gearbeitet, für die in reiner Stickstoffatmosphäre die hexagonale Phase des Molybdännitrids (MoN) erzeugt wird, aber durch Sauerstoffzugabe allmählich der Stickstoff teilweise durch den Sauerstoff ersetzt wird und dadurch Molybdänmonoxid in die Schicht gebildet wird. Da Molybdänoxid (MoO) auch bei mechanisch anspruchsvollen Anwendungen stabil in und auf der Schicht vorhanden bleibt, verhindert oder bremst es eine weitergehende Nachoxidation der MoN-Schicht und stabilisiert somit auch das Molybdännitrid.

Die erfindungsgemäss synthetisierten Schichten weisen weder die typischen Molybdändioxid- noch die Molybdäntrioxid-Peaks im Röntgenspektrum auf. Diese Schichten zeigen aber bei der Analyse (z.B. bei quantitativer Elementanalytik durch elastische Vorwärtsstreuung (ERD) hochenergetischer schwerer Ionen) einen Sauerstoffgehalt von mehr als 3 at.%, aber weniger als 50 at.%, falls man den Sauerstoff auf das reines MoO-Monoxid bezieht.

Für spezifische Anwendungen können der Molybdännitridoxidschicht Mo-N-O weitere Elemente wie Kohlenstoff (C), Bor (B), Silizium (Si), Wolfram (W) oder Kupfer (Cu) zugefügt.

Bei vielen Stahlarten tritt das Problem auf, dass sie auf die Oberfläche von Bauteilen oder Werkzeugen, die mit konventionellen Beschichtungen, wie z.B. TiAlN oder CrAlN beschichtet sind, aufschmieren, was insbesondere bei der Zerspanung von Metallen, wie z.B. Drehen, Räumen oder Fräsen ein unerwünschter Effekt ist. Es wurde weiter festgestellt, dass die Aufschmierung von solchen Stählarten durch die Beschichtung mit MoN mittels Funkenverdampfung zumindest im Wesentlichen verhindert wird.

Das gilt insbesondere auch dann, wenn Molybdännitrid in angepassten Mengen in andere Nitride eingebaut wird. Dies bedeutet, dass die ursprünglichen sehr guten Eigenschaften, welche die Basis-Nitride aufweissen erhalten bleiben, aber durch das Hinzufügen von Molybdännitrid zusätzlich die Aufschmierung verhindert werden kann. Auch hier kann der Abbau des MoN durch unkontrollierte Nachoxidation verhindert oder zumindest abgebremst werden indem gezielt MoN zum Teil durch MoO, vorzugsweise an der Schichtoberfläche in erhöhtem Masse oder vollständig ersetzt wird.

Des Weiteren konnten mittels Funkenverdampfen und gepulstem Funkenverdampfen erstmals Molybdänoxid enthaltende, relativ dicke Schichten (> 50 nm) mit einer hohen Konzentration (≥ 50 at.%) an Molybdänoxid hergestellt werden. Die Synthese der Molybdännitridoxidschichten Mo-N-O in einem PVD Prozess erfolgt durch reaktive Beschichtung mit Plasmaunterstützung, beispielsweise mittels reaktiven Funkenverdampfen, indem einen kathodischen Funken auf einem Molybdän-Target in Stickstoffatmosphäre zwischen typischerweise 0.1 Pa und 10 Pa betrieben wird. Die Zugabe von Sauerstoff resultiert in der Bildung von Molybdänoxid Mo-O Verbindungen.

Die bekannten Oxide, die aus Molybdän gebildet werden, nämlich MoO₂ und MoO₃ besitzen, wie beschrieben die Eigenschaft, dass sie leicht flüchtig sind. Vom MoO₃ weiss man, dass es bei Temperaturen zwischen 500°C und 600°C sublimiert, d.h. in die Gasphase übergeht. In einem reaktiven Plasma findet dieser Übergang in die Gasphase durch die hohe Reaktivität des Plasmas schon bei wesentlich niedrigeren Substrattemperaturen statt. D.h. der Übergang wird eher durch die Reaktivität des Plasmas als durch die Substrattemperatur bewirkt. D.h. wiederum, dass die gasförmigen Mo-O Verbindungen sehr genau kontrolliert werden müssen, damit bei der Schichtabscheidung der Einbau des Festschmierstoffes in Form von pulverartigen Molybdänoxid (MoO₂ oder MoO₃) verhindert wird.

Zur Verdeutlichung soll das am Beispiel von einigen Rasterelektronmikroskopische Aufnahmen (SEM-Abbildungen) von Bruchquerschnitten an Mo-N-, Mo-O, und Mo-N-O-Schichten diskutiert werden.

In Abb.1 ist Skizze einer typischen Schichtmorphologie für eine Molybdännitridschicht MoN, die mittels reaktiver Funkenverdampfung hergestellt wurde. Die Molybdännitridschicht MoN haben die Erfinder auf einer Haftschicht aus Chromnitrid CrN (Dicke der Haftschicht ca. 300 nm) abgeschieden. Hergestellt wurde die MoN Schicht bei einer Temperatur von 450° C mit einem Mo-Target und einem Funkenstrom von 220 A. Der Stickstoffdruck betrug 3.5 Pa und es wurde ein Substratbias von 20 V verwendet.

Die SEM-Aufnahme des Bruchquerschnittes zeigt eine dichte Schichtmorphologie. Härtemessungen ergaben typische Werte von HV 3000±500. Die Schicht zeigte im Vergleich zu gewöhnlich mittels Funkenverdampfung hergestellten Schichten, eine aussergewöhnlich niedrige Rauhigkeit von Rz = 1.07 µm und Ra = 0.13 µm.

Zusätzlich wurden auch die Reibkoeffizienten von den abgeschiedenen Schichten ermittelt. Dafür wurde einen SRV Test bzw. ein Tribometer von der Fa. Optimol Instruments Prüftechnik GmbH angewendet. Bei der Durchführung des SRV Tests wurden die beiden in der Testkammer eingebauten Prüfkörper (eine Kugel auf einer Scheibe) mit vorgegebener Normalkraft aufeinandergepresst. Während der Messung oszillierte der obere Prüfkörper, in diesem Fall der Gegenkörper (eine unbeschichtete Kugel aus Stahl 100Cr6) auf dem unteren Prüfkörper (die beschichtete Prüfscheibe). Für die Messung wurden Frequenz, Gleitweg, Prüfkraft, Prüftemperatur und Prüfdauer vorgegeben. Während der Messung wurden die Reibungskräfte kontinuierlich durch einen Sensor aufgenommen und somit konnten die Reibwerte automatisch berechnet werden. Der während der Messung an beiden Prüfkörpern entstandene Verschleiss wurde auch nach der Messung bewertet.

Die gemessenen Reibkoeffizienten und die Beobachtungen hinsichtlich der Aufschmierung des verwendeten Gegenkörpers aus Stahl 100Cr6 auf die mit MoN beschichteten Prüfscheiben im SRV Test sind in der Tabelle 1 aufgelistet. Für alle Messungen im SRV Test wurden die gleichen Parameter hinsichtlich Frequenz, Gleitweg, Prüfkraft, Prüftemperatur und Prüfdauer vorgegeben. Allerdings wurden die Messungen nach drei verschiedenen Testabläufen durchgeführt, wie auch in Tabelle 1 angegeben.

Da für alle Messungen ein Gegenkörper bzw. eine Kugel aus Stahl 100Cr6 angewendet wurde, war die Erscheinung von Aufschmierungen vom Stahl auf die Kontaktoberfläche der beschichteten Prüfscheiben zu erwarten, was unter den vorgegebenen Bedingungen gewöhnlich ist. Allerdings haben die Erfinder erstaunlicherweise beobachtet, dass keine Aufschmierung des Gegenkörpers an der Oberfläche der mit MoN beschichteten Prüfscheiben auftrat.

**Tab. 1: Reibkoeffizienten der mittels Funkenverdampfung hergestellten MoN-Schichten und Feststellung von Aufschmierung der Gegenkörper auf die Schichten im SRV Test**

| Unterschiedliche Testabläufe bei der Messungen im SRV Test | Gemessene Reibkoeffizienten [µm] | Aufschmierung vom Stahl 100Cr6 auf MoN |
|---|---|---|
| Trockenlaufversuche mit beschichteten Prüfscheiben, die nicht nach der Beschichtung behandelt wurden. | ∼ 0.6 | keine Aufschmierung |
| Trockenlaufversuche mit beschichteten Prüfscheiben, die zusätzlich nach der Beschichtung poliert wurden. | ∼ 0.5 | keine Aufschmierung |
| Geschmierte Versuche mit beschichteten Prüfscheiben, die zusätzlich nach der Beschichtung poliert wurden. | ∼ 0.08 | keine Aufschmierung |

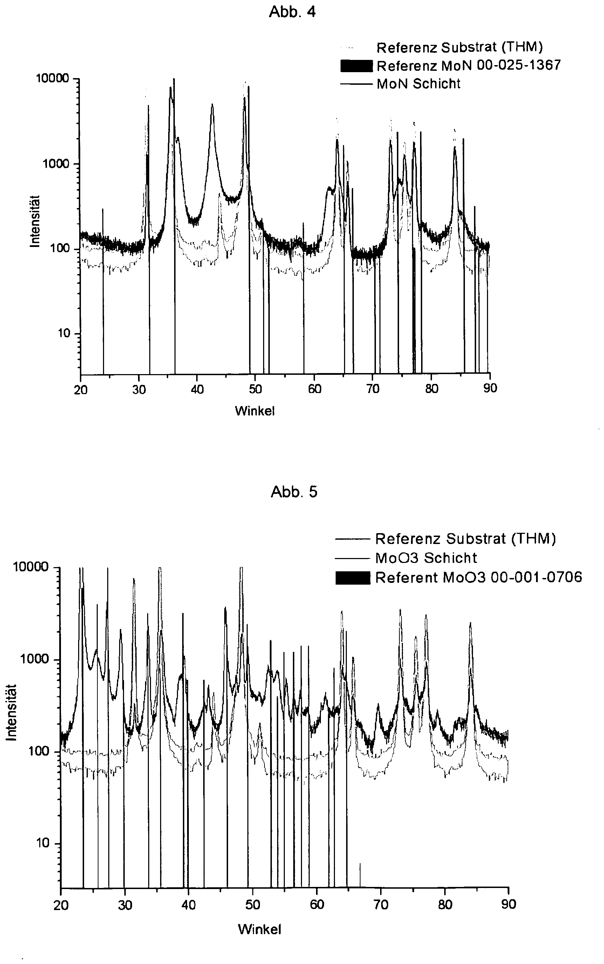

Das XRD Spektrum in Abb.4 zeigt die typischen Bragg Reflexe für das mittels Funkenverdampfung hergestellte MoN.

In Abb. 2 wird die Skizze einer Schicht aus Mo-N-O, abgeschieden auf einer CrN Haftschicht gezeigt. Die Mo-N-O Schicht wurde auf einer ca. 300 nm CrN Haftschicht, unter ähnlichen Bedingungen, wie die oben beschriebenen MoN Schichten, bei 450°C Substrattemperatur und einem Funkenstrom von 220 A hergestellt wurde. Dem auf den Stickstoffdruck von 3.5 Pa geregeltem Prozess wurde, nach einer kurzen Phase von wenigen Minuten im reinen Stickstoff, Sauerstoff beigegeben, wobei der Sauerstofffluss über ca. 2h von 50 sccm auf 800 sccm graduell bzw. linear erhöht wurde.

Der SEM Bruchquerschnitt zeigt einen deutlichen Übergang zu einem losen Schichtaufbau im letzten Drittel der Schicht (wie in Abb. 2 skizziert wurde).

Die obere Schicht zeigte die lose abgeschiedene MoO₃ Schicht, die zwar Schmiereigenschaften aufweist, aber kaum mechanische Festigkeit.

Es ist dem Fachmann klar, dass der Einbau einer solchen Schicht in ein Schichtsystem zu Haftungsproblemen führt. Die Erfinder führen diesen unerwünschten Aufbau im letzten Drittel der Schicht auf die schnelle Reaktion der Molybdänatome in der Beschichtungskammer und sogar in der schon erzeugten MoN Schicht mit dem in die Beschichtungskammer zugegebenen Sauerstoff zurück. Diese schnelle Reaktion, so vermuten die Erfinder, begünstigt ab einem bestimmten Sauerstofffluss die Formation von flüchtigen Molybdänoxiden, wie MoO₂ und MoO₃ während der Beschichtung.

Deshalb unterstreicht dieses Ergebnis, dass es sehr wichtig ist, die Sublimation der MoO₂ und MoO₃ während der Beschichtung zu verhindern. D.h. den Sauerstofffluss so zu kontrollieren, dass im Wesentlichen nur nicht flüchtige Molybdänoxide, wie z.B. Molybdänmonoxid (MoO) in das Schichtsystem eingebaut wird.

Allerdings kann es vorteilhaft sein, dass zum Schichtabschluss erfinderisch absichtlich mit hohem Sauerstofffluss gearbeitet wird, damit es zur Bildung von Molybdäntrioxid (MoO₃) an der Schichtoberfläche kommt und somit eine weiche Einlaufschicht erzeugt wird, z.B. MoO₃ auf MoO.

Abb. 5 zeigt das durch Röntgenbeugungsanalyse (XRD) generierte XRD-Spektrum der in Abb. 2 aufgenommenen Mo-O-N Schicht. Der Vergleich mit der Referenz aus der ISDN Datenbank bestätigt auch die Formierung des als guter Festkörperschmierstoff wirkenden MoO₃.

Für die in Abb. 2 skizzierte Schicht konnte die Oberflächenrauhigkeit nicht ermittelt werden, da der obere Teil der Schicht zu weich für reproduzierbare Messungen war. Wieder wurde der Reibkoeffizient der nicht nachbehandelten Schichten im SRV Test bestimmt. Die SRV Tests wurden im Trockenlauf und bei gleichen Testparametern wie oben erwähnt durchgeführt. Diese Schichten wurden nicht nachpoliert, um den eventuellen Verlust der MoO₃ Schicht an der Beschichtungsoberfläche vor dem Start der SRV-Tests zu vermeiden.

Der so gemessene Reibkoeffizient dieser Schichten war 0.75, was erstaunlicherweise höher als der Reibkoeffizient von den reinen MoN Schichten, die bei genau gleichen Testbedingungen (gleiche Testparameter und gleicher Testablauf) im SRV Test charakterisiert wurden. Die Erfinder vermuten, dass dieses unerwartete Ergebnis auf den eventuellen Einbau von Molybdändioxid (MoO₂) in die Mo-N-O zurückzuführen ist. Wie in der Literatur bekannt ist und schon oben erwähnt wurde, ist das MoO₂ stark abrasiv. Wie die Entstehung von MoO₂ beim erfinderischen Herstellungsprozess vermieden werden kann, wird weiter unten beschrieben.

In Abb. 3 wurde den SEM-Schichtquerschnitt einer hergestellten Schicht mit kontrolliertem Sauerstoffgehalt skizziert. Die Schicht zeigte eine deutlich unterschiedliche Morphologie als die von der Schicht, die in Abb.2 skizziert ist. Die Morphologie der hergestellten Schicht mit kontrolliertem Sauerstoffgehalt ähnelt der des MoN, obwohl einen Anteil von mehr als 5 at.% Sauerstoff in der Schicht mit EDX nachweisbar ist.

Der durchgeführte Herstellungsprozess führt im Wesentlichen nur zu einer Phasenbildung des Molybdänmonoxids (MoO) in der MoN Schicht, wobei sich die atomare Konzentration des Sauerstoffs in der Mo_{z}(N_{d}Oₑ) Schicht zwischen einem Wert von e = 0.03 und 1 unter der Bedingung z ≥ d + e mit d, e und z in at%.

Der Anteil z - (d + y) von Mo entspricht dann dem nicht mit Stickstoff und/oder Sauerstoff reagiertem Molybdän. Dies tritt dann zum Beispiel beim Funkenverdampfen in Form von in die Schicht eingebauten Konglomeraten auf, die aus nicht vollständig durchreagiertes Molybdän herrühren und in der Fachwelt als Spritzer (Droplets) bekannt sind.

Die Schicht, die in Abb. 3 skizziert ist, wurde ohne Haftschicht abgeschieden. Zur Abscheidung dieser Schicht wurden 2 Molybdäntargets angewendet, die beide mit 220 A Funkenstrom betrieben wurden. Der Beschichtungsprozess wurde auf einen konstanten Totaldruck von 4 Pa geregelt, der zunächst durch das Einlassen vom Stickstoff in die Beschichtungskammer erstellt wurde. Die Prozessparameter wurden während des gesamten Abscheidungsprozesses wechselweise und kontinuierlich variiert, indem dem regulierten Totaldruck einen Sauerstofffluss von 50 sccm jeweils über 40 s beigegeben wurde und anschliessend wieder den Sauerstofffluss für 3 min unterbrochen wurde bis die gesamte Schichtdicke erreicht wurde.

Durch energiedispersive Röntgenmikrobereichsanalyse (EDX) wurde festgestellt, dass die so abgeschiedene Schichten einen Anteil von mehr als 10 at.% Sauerstoff aufweisen.

Dennoch konnten keine ausgeprägten Molybdändioxid- oder Molybdäntrioxid-Peaks in das XRD-Spektrum dieser Schicht (siehe Abb. 6) detektiert werden, welche hingegen in Abb. 5 zu sehen sind.

Somit zeigt es sich, dass die mit der Funkenverdampfung hergestellten Mo-O Schichten über den Sauerstoffluss so kontrolliert werden können, dass das stabile und duktile MoO (Molybdänmonoxid) hergestellt werden kann und in eine MoN Matrix eingebaut werden kann oder auch als Einzelschicht synthetisiert werden kann. Der Übergang zu MoO₃ ohne oder mit sehr wenig Einbau vom abrasiven MoO₂ in die Schicht, lässt sich in einer schnellen Oxidrampe realisieren und damit ist die Herstellung einer festen Oberflächenschmierung im gleichen Prozess möglich.

Wie oben bereits erwähnt eignet sich eine derart hergestellte äussere MoO₃-Schicht besonders gut als Einlaufschicht.

Durch die Flexibilität der angewendeten Funkenverdampfen- und gepulsten Funkenverdampfensprozessen können auch MoO Schichten in jede beliebige Schicht eingebaut werden. Die MoO Schichten und MoO + MoO₃ Schichten, wobei MoO₃ als Einlaufschicht verwendet wird, werden insbesondere als äussere Schichten eingebaut, um eine bestimmte Weichheit oder ein verbessertes Einlaufverhalten im Vergleich zum ursprünglichen Schichtsystem einstellen zu können, damit zum Beispiel der Verschleiss vom Gegenkörpern in einem tribologischen System minimiert wird und gleichzeitig ein stabilisiertes Oxidationsverhalten von Mo-haltigen Schichten vorhanden ist.

Von Vorteil ist auch den Einbau von MoO in jeder beliebigen Schicht und insbesondere in anderen Oxidschichten, wie z.B. Al-O, CrO, Zr-O, Ti-O und/oder auch in Mischoxidschichten, wie z.B. (Al,Cr)O, (Zr,Cr)O oder Cr-O um z.B. Geschmeidigkeit einzustellen.

Dafür muss die Reaktivität von den anderen Elementen gegenüber dem Sauerstoff sehr genau betrachtet werden. Man kann zum Beispiel durch verschiedene Versuche je mit schrittweise erhöhtem Sauerstofffluss analysieren, ab welchem Sauerstofffluss Molybdändioxid und Molybdäntrioxid in die Schicht formiert werden. Bleibt man im eigentlichen Beschichtungsprozess dann bei niedrigeren Sauerstoffflüssen, so wird die Formierung von den unerwünschten Molybdänoxiden vermeiden.

Wie die Erfinder ermitteln konnten, ist es von besonderem Vorteil, zwischen der MoO Schicht und dem Substrat eine MoN enthaltende Schicht vorzusehen. Hierdurch wird die mechanische Stabilität der Schicht am Beispiel von der Härte und der Haftfestigkeit innerhalb der Schicht auch weiter verbessert.

Es kann dann von Vorteil sein, neben dem Molybdän noch weitere Metallkomponenten in der Schicht vorzusehen.

Eine besonders bevorzugte Variante der Erfindung ist die Herstellung eines Mo-N-O Schicht mittels Funkenverdampfen und/oder gepulstem Funkenverdampfen, die z.B. folgendes hergestellt werden kann:
• Nach Einlassen von Stickstoff in die Beschichtungskammer wird in der Stickstoffatmosphäre auf einem als Kathode dienenden Molybdäntarget ein Funken gezündet, wodurch es zur Verdampfung von Molybdän und/oder bereits reagiertem Molybdännitrid kommt. Nach Erreichung einer bestimmten Schichtdicke wird zusätzlich in die Beschichtungskammer wenig Sauerstoff eingelassen und somit eine Mo-N-O Schicht hergestellt, die die sehr guten Eigenschaften von Mo-N aufweist aber zusätzlich aufgrund der in Schicht eingebauten kleinen Mengen von Mo-O Verbindungen auch verbesserte Schmierstoffeigenschaften und/oder Geschmeidigkeit bietet.
• Nach Einlassen von Stickstoff in die Beschichtungskammer wird in der Stickstoffatmosphäre auf einem als Kathode dienenden Molybdäntarget ein Funken gezündet, wodurch es zur Verdampfung von Molybdän und/oder bereits reagiertem Molybdännitrid kommt. Nach Erreichung einer bestimmten Schichtdicke wird zusätzlich in die Beschichtungskammer wenig Sauerstoff eingelassen und nach einer bestimmten Zeit der Sauerstofffluss nochmals abgebrochen, so dass weiter wieder nur Molybdännitrid erzeugt wird. Der Beschichtungsprozess wird so alternierend weitergeführt bis der gewünschten gesamten Schichtdicke der mehrlagigen Schicht Mo-N/Mo-N-O/Mo-N/Mo-N-O... erreicht wird. Die Dicke der Einzelllagen so wie die gesamte Schichtdicke wird anwendungsbezogen angepasst. Auch mit dieser Variante werden in einer einzigen Beschichtung die sehr guten Eigenschaften von Mo-N und die Schmierstoffeigenschaften und/oder Geschmeidigkeit von Mo-O kombiniert.

Ähnliche Schichtsysteme lassen sich auch mit legierten Targets von Mo in Kombination mit anderen Metallen herstellen, oder indem man ausser das Mo-Target oder die Mo-Targets auch Targets aus anderen Metallen und/oder Legierungen und/oder anderen Materialien während der Beschichtungsprozess aktiviert bzw. verdampfen lässt.

Zur Herstellung von ähnlichen Schichtsystemen wie die bereits oben erwähnten aber mit besonderen mechanischen Eigenschaften gibt es Schichtsysteme, die Karbide umfassen vorgesehen. Diese Schichtsysteme werden auch mittels Funkenverdampfen und/oder gepulstem Funkenverdampfen indem während der Beschichtung zusätzlich ein kohlenstoffhaltiges Gas eingelassen wird und/oder durch die Aktivierung bzw. Verdampfung von Kohlenstoff-Targets und/oder kohlenstoffhaltigen Targets

Allgemein ausgedrückt liegt dann ein Schichtsystem gemäss einer besonders bevorzugten Variante vor, wenn mindestens zwei Schichten umfasst:
- Eine erste Schicht, die als Hauptbestandteil MoN aufweist und damit sehr gute mechanische Stabilität besitzt und
- Eine zweite Schicht, die als Hauptbestandteil Molybdänmonoxid aufweist und damit sehr gute Schmierstoffeigenschaften besitzt.

Der Übergang zwischen erster und zweiter Schicht kann graduell ausgebildet sein.

Eine wesentliche Verbesserung der Zähigkeit erreicht man durch die Abscheidung von mehrlagigen Schichten. Gleichzeitig wird auf diese Weise eine Rissausbreitung von der Oberfläche zum Grundwerkstoff hin unterbunden. Des Weiteren kann in vielen Fällen die maximale Schichtdicke gesteigert werden, da mit dem mehrlagigen Schichtverbund mechanische Eigenspannungen in der Schicht im Vergleich zur Monolagenschicht reduziert werden können.

Um eine gute Festigkeit innerhalb der gesamten Schicht zu gewährleisten, ist eine entsprechende Anpassung der Werkstoffeigenschaften der verschiedenen Lagen erforderlich. Das kann zum Beispiel durch die Erzeugung gradierter Grenz-/Übergangsschichten oder durch die Abscheidung von Zwischenlagen erzielt werden.

### Detaillierte Beschreibung der Erfindung anhand von Beispielen

Die folgenden Beispiele dienen dazu, die Erfindung im Detail darzulegen, sie sollten jedoch nicht als eine Beschränkung deren Umfang angesehen werden.

Beispiel 1: Allgemein ist von Vorteil, dass Kolbenringe und Wellendichtringe über gute mechanische Stabilität und gleichzeitig gute Schmierstoffeigenschaften und/oder Geschmeidigkeit verfügen. Im vorliegenden Beispiel wurde einen Kolbenring aus rostfreiem Stahl mittel Funkenverdampfen mit Mo-N beschichtet. Hierzu wird der Kolbenring in die Beschichtungskammer einer Beschichtungsanlage platziert. Die Beschichtungskammer wird evakuiert und zur Reinigung/Aktivierung der Oberfläche wird die Oberfläche vor der Beschichtung geheizt und geätzt. Nach Einlassen von Stickstoff in die Beschichtungskammer wird in der Stickstoffatmosphäre auf einem als Kathode dienenden Molybdäntarget ein Funken gezündet, wodurch es zur Verdampfung von Molybdän und/oder bereits reagiertem Molybdännitrit kommt. Abscheiden des Materials auf der Kolbenoberfläche führt zur Bildung einer 2µm dicken Mo-N-Schicht. Das Beschichtungsverfahren erlaubt die anwendungsbezogene Anpassung der Schichtdicke.

Durch die Beschichtung mittels Funkverdampfung mit Mo-N vom Kolben sind die Erfinder darauf gekommen, dass die Reibung während des Betriebs deutlich reduziert wird und auch die Lebensdauer des Kolbenringes deutlich erhöht wird. Die Erfinder führen die verminderte Reibung u.a. auf die durch das Funkenverdampfen in die Schicht eingebauten Spritzer zurück. Diese Spritzer sind zahlenmässig so gering, dass sie die Stabilität und damit die Härte des Mo-N nicht wesentlich beeinträchtigen, jedoch so zahlreich vorhanden, dass das so vorhandene Molybdän die bereits guten Gleiteigenschaften der durch den Herstellungsprozess glatten Mo-N Schicht durch seine Schmierstoffeigenschaften noch weiter verbessert.

Ein besonderer Vorteil des Funkenverdampfens ist die Möglichkeit, Funktionsflächen von Präzisionsbauteilen zu beschichten da Schichtdicken genau gemäss der erforderlichen Präzision bzw. den Massgaben im tribologischen System abgeschieden werden können

Wird beim oben genannten Beschichtungsverfahren Pulstechnologie eingesetzt so kann das Wachstum verschiedener Phasen vom Mo-N durch die Einstellung verschiedener Pulsparameter bei der Anlegung einer gepulsten Biasspannung und/oder beim Betrieb einer gepulsten Funkverdampfungsquelle sehr gut reguliert werden. Hierdurch wird ermöglicht, dass durch eine bestimmte Einstellung der Beschichtungsparameter, insbesondere der Pulsparameter, das Wachstum einer bestimmten Phase begünstigt wird und Mo-N Schichten mit besonderen Eigenschaften, angepasst an die Verwendung des beschichteten Bauteils, hergestellt werden können. Es ist auch möglich durch Variation der Beschichtungsparameter während des Beschichtens mehrlagige Mo-N Schichten mit verschiedenen Phasen beispielsweise auch abgewechselt aufzubauen. Insbesondere kann somit ein Schichtsystem aufgebaut werden, bei dem sich kubisches Mo-N mit hexagonalem Mo-N abwechseln. Ein solches, mindestens zwei Schichten umfassendes Schichtsystem umfasst dann zumindest eine innere kubische und damit harte Schicht und eine äussere hexagonale und damit weichere Schicht.

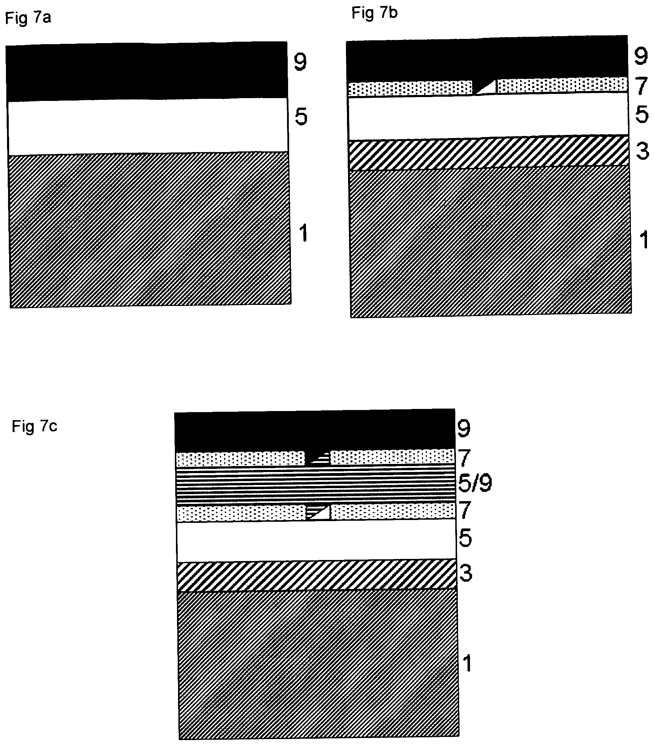

Gemäss einer weiteren Ausführungsform wird, z.B. bei besonders hochbeanspruchte Kolben in Verbrennungsmotoren oder auch, um auf externe Zwischenstoffe verzichten zu können, ein zweilagiges Schichtsystem auf die Funktionsfläche bzw. auf dem Substrat 1 aufgetragen werden: Die erste Schicht ist dann eine Mo-N-Schicht 5 und die zweite Schicht eine Molybdänmonoxid-Schicht 9 wie im Figur 7a dargestellt.

Auch hier kann, wie bereits weiter oben beschrieben, eine zusätzliche Haftschicht vorgesehen sein, wie in Figur 7b gezeigt. Die Haftschicht 3 ist zwischen dem Substrat 1 und der ersten Schicht 5 im Schichtsystem vorgesehen. Die Haftschicht kann sowohl eine reine Metallschicht (wie zum Beispiel Cr, Mo, Ti, Si) oder auch ein Komposite (wie zum Beispiel Me-N oder Me-NC) sein, wobei Me auch eine Kombination von Metallen möglich ist.

Der Übergang zwischen der ersten Schicht 5 und der zweiten Schicht 9 kann als Gradient ausgebildet werden, derart, dass mit zunehmendem Abstand von der Oberfläche des Substrates die Mo-N-Konzentration abnimmt und gleichzeitig die Mo-O Konzentration zunimmt. Dies führt zu einer sehr guten Haftfestigkeit innerhalb des Schichtsystems. Entsprechendes gilt für alle Schichtübergänge der in dieser Beschreibung aufgeführten Schichtsysteme. Insbesondere kann der Gradient die ganze Schicht und/oder die ganzen Schichten umfassen.

Eine weitere Verbesserung der Zähigkeit im Schichtsystem kann durch die Abscheidung von mehreren nanolagigen Schichten, oder durch die Herstellung von Nanoverbundstrukturen in dem zum Beispiel die härtere Phase in der Form von Nanokörnern in einer Matrix aus der weicheren Phase eingebetet ist.

Von X-Schicht ist im Rahmen der vorliegenden Beschreibung dann die Rede, wenn die Schicht überwiegend X enthält, wobei X ein elementarer Stoff oder eine Verbindung sein kann.

Im Rahmen der vorliegenden Beschreibung wurde eine Beschichtung offenbart, die mindestens eine molybdänhaltige Schicht mit Molybdänoxid umfasst und die dadurch gekennzeichnet ist, dass das Molybdänoxid im Wesentlichen Molybdänmonoxid ist.

Die Beschichtung kann zum Beispiel eine Molybdänoxidschicht enthalten, die im Wesentlichen Molybdänmonoxid umfasst. Eine Schicht MoO-Schicht lässt sich von MoO₂- und MoO₃-Schichten unterscheiden indem zum Beispiel das XRD Spektrum der Molybdänmonoxidschicht (MoO) im Wesentlichen weder MoO₂ Peaks noch MoO₃ Peaks aufweist.

Eine bevorzugte Variante der Beschichtung kann zum Beispiel zusätzlich auch eine Molybdännitridschicht umfassen.

Die erfindungsgemässe Beschichtung enthält auch eine Mo-N-O Schicht die Molybdänstickstoffbindungen und Molybdänoxidbindungen umfasst, wobei im Wesentlichen die Molybdänatome maximal mit einem Sauerstoffatom eine Verbindung bilden und in der Beschichtung vorzugsweise Molybdänmonoxid enthalten ist.

Eine bevorzugte Variante der erfindungsgemässen Beschichtung mit mindestens einer Mo-N-O Schicht charakterisiert sich indem die Mo-N-O Schicht zwischen einer Molybdännitridschicht und einer Molybdänmonoxidschicht liegt.

Das atomare Konzentrationsverhältnis in der Mo-N-O Schicht kann durch die folgende Formel beschrieben werden: Mo_{z}(N_{d}Oₑ) wobei:
e: die atomare Sauerstoffkonzentration in der Mo-N-O Schicht ist
d: die atomare Stickstoffkonzentration in der Mo-N-O Schicht ist
z: die atomare Molybdänkonzentration in der Mo-N-O Schicht ist und z ≥ y.

Die Mo-N-O Schicht kann auch eine gradierte Schicht sein, wobei die Stickstoffkonzentration von der substratnahen Grenzfläche zur oberflächennahen Grenzfläche der Mo-N-O-Schicht abnimmt während die Sauerstoffkonzentration zunimmt.

Ebenfalls kann die Mo-N-O Schicht, eine gradierte Schicht sein, wobei die Sauerstoffkonzentration von der substratnahen Grenzfläche zur oberflächennahen Grenzfläche der Mo-N-O-Schicht abnimmt während die Stickstoffkonzentration zunimmt.

Eine Beschichtung kann auch als mehrlagiges Schichtsystem abgeschieden werden, wobei mehrere MoN- und MoO-Schichten alternierend abgeschieden werden und können auch z.B. mehrere Mo-N-O Schichten enthalten, die z.B. zwischen den MoN- und MoO-Schichten liegen und die als gradierte Schichten mit angepassten Variationen der Stickstoff- und Sauerstoffkonzentrationen zur Verbesserung der Haftfestigkeit innerhalb der Schicht abgeschieden werden können.

Die erfindungsgemässe Beschichtung kann auch zusätzlich eine Deckschicht mit MoO₃, wenn das MoO₃ anwendungsbezogen weitere Vorteile mitbringen kann. Somit kann auch die Beschichtung zwischen dem Grundkörper und der Mo-haltigen Schicht eine oder mehrere Haftschicht(en) und/oder Funktionsschicht(en) umfassen.

Eine auch bevorzugte Variante ist eine Beschichtung die mindestens eine Mo-haltige umfasst, die insbesondere sehr gute mechanische Stabilität aufweist und (Mo_{1-x,}Meₓ)AₐB_{b}C_{c}, enthält, wobei 0 ≤ x ≤ 0.99, vorzugsweise 0 ≤ x ≤ 0.5 und Me ein Metal aus der Gruppe von W, Ti, Al, Cr, Si, Zr, Ta, Nb, Ag, Cu und V ist, oder der Kombination aus zwei oder mehreren Metallen dieser Gruppe und
A: Stickstoff (N) ist mit 0.5 ≤ a ≤ 1
B: Kohlenstoff (C) ist mit 0 ≤ b ≤ 0.5
C: Sauerstoff (O) ist mit 0 ≤ c ≤ 0.5
und mit a, b, und c in at% zwischen den Elementen N, C und O angibt mit a+b+c = 1 und zusätzliche weitere Elemente vorgesehen sein können, aber vorzugsweise nicht vorgesehen sind, und x ≥ c.

Ebenso ist eine bevorzugte Variante eine Beschichtung die mindestens eine Mo-haltige Schicht umfasst, die insbesondere sehr gute Schmierstoffeigenschaften und Gleiteigenschaften aufweist und (Mo_{1-y,}Me_{y})AᵤBᵥC_{w}, enthält, wobei 0 ≤ y ≤ 0.99, vorzugsweise 0 ≤ y ≤ 0.5 und
Me ein Metal aus der Gruppe von W, Ti, Al, Cr, Si, Zr, Ta, Nb, Ag, Cu und V ist, oder der Kombination aus zwei oder mehreren Metallen dieser Gruppe und
A: Stickstoff ist mit 0 ≤ u ≤ 0.5
B: Kohlenstoff ist mit 0 ≤ v ≤ 0.5
C: Sauerstoff ist mit 0.5 ≤ w ≤ 1
und mit u, v, und w at% zwischen den Elementen N, C und O angeben mit u+v+w = 1 und zusätzliche weitere Elemente vorgesehen sein können, aber vorzugsweise nicht vorgesehen sind, und y ≥ w.

Bevorzugt konnte auch eine Beschichtung so aufgebaut werden, die
- mindestens eine erste Mo-haltige Schicht, die insbesondere eine sehr gute mechanische Stabilität aufweist (gemäss der oben beschriebene (Mo_{1-x,}Meₓ)AₐB_{b}C_{c} Schicht) und
- mindestens eine zweite Schicht, die insbesondere sehr gute Schmierstoffeigenschaften und Gleiteigenschaften aufweist (gemäss der oben beschriebene (Mo_{1-y,}Me_{y})AᵤBᵥC_{w} Schicht)
umfasst.

Eine bevorzugte Variante des Verfahrens zur Herstellung der Beschichtung ist ein PVD-Verfahren oder kombiniertes PVD/CVD Verfahren, wobei das Molybdänmonoxid in der Molybdänmonoxid umfassenden Schicht mittels Funkenverdampfen abgeschieden wird.

Eine weitere bevorzugte Variante des Verfahrens zur Herstellung der Beschichtung ist ein PVD-Verfahren, wobei die molybdänhaltigen Schichten mittels Funkenverdampfen von mindestens die molybdänhaltigen Schichten mittels Funkenverdampfen von mindestens einem molybdänhaltigen Target in Reaktivatmosphäre hergestellt werden.

Als Materialquelle für die molybdänhaltigen Schichten können sowohl Molybdäntargets als auch legierte molybdänhaltige Targets angewendet werden, die zum Beispiel schmelzmetallurgisch oder pulvermetallurgisch hergestellt werden können.

Bauteile können anwendungsbezogen mit der besser geeigneter Variante der erfindungsgemässen Beschichtung beschichtet werden.

Insbesondere können Zerspanungswerkzeugen und Umformwerkzeugen, die zur Fertigung von Bauteilen aus Metallen oder Metalllegierungen erfindungsgemäss beschichtet werden, um Aufschmierungen der bearbeiteten Metalle oder Metalllegierungen auf die beschichtete Oberfläche des Werkzeugs zu reduzieren oder vorzugsweise vollständig zu vermieden.

### Bildlegende:

Abb. 1: Skizzierung der Schichtmorphologie einer mittels Funkenverdampfung MoN Schicht mit CrN Haftschicht im SEM Bruchquerschnitt.

Abb. 2: Skizzierung der Schichtmorphologie einer mittels Funkenverdampfung Mo-N/Mo-N-O/Mo-O Schicht mit CrN Haftschicht im SEM Bruchquerschnitt, wobei die Molybdänoxidphasen MoO₂ und MoO₃ in der Schicht durch XRD nachweisbar sind.

Abb. 3: Skizzierung der Schichtmorphologie einer mittels Funkenverdampfung hergestellten Mo-N/Mo-N-O/Mo-O Schicht ohne Haftschicht im SEM Bruchquerschnitt, wobei keine Molybdänoxidphasen MoO₂ und MoO₃ in der Schicht durch XRD nachweisbar sind, obwohl mehr als 10 Atomprozent Sauerstoff in der Schicht durch EDX nachweisbar ist. Die Schicht wurde durch zeitlich unterbrochene Zugabe eines Sauerstoffflusses von 50 sccm hergestellt (bei 4 Pa druckgeregelt) mit einer on-Zeit von 40 s und einer off-Zeit von 3 min.

Abb. 4: Typisches XRD Spektrum einer MoN Schicht, deren Bragg Reflexe in Übereinstimmung mit der MoN Referenz ISDN 00-025-1367 sind.

Abb. 5: Typisches XRD Spektrum einer MoO₃ Schicht, deren Bragg Reflexe in Übereinstimmung mit der MoO₃ Referenz ISDN 00-001-0706 sind.

Abb. 6: Typisches XRD Spektrum einer Molybdänmonoxid-Schicht.

### Bezugszeichenliste:

- 1:: Substrat
- 3:: Haftschicht und/oder Funktionsschicht
- 5:: Erste Schicht
- 7:: Übergangsschicht
- 9:: Zweite Schicht

## Patentansprüche

1. Bauteil mit einer Beschichtung, die mindestens eine molybdänhaltige Schicht mit Molybdänoxid umfasst, **dadurch gekennzeichnet, dass** das Molybdänoxid im Wesentlichen Molybdänmonoxid ist und die Beschichtung mindestens eine Molybdännitridschicht umfasst und die Beschichtung mindestens eine Mo-N-O Schicht umfasst, die Molybdänstickstoffbindungen und Molybdänoxidbindungen umfasst, wobei im Wesentlichen die Molybdänatome maximal mit einem Sauerstoffatom eine Verbindung bilden.

2. Bauteil nach Anspruch 1, **dadurch gekennzeichnet, dass** die Beschichtung mindestens eine Molybdänoxidschicht umfasst, die im Wesentlichen Molybdänmonoxid umfasst und dass das XRD Spektrum der Molybdänmonoxidschicht im Wesentlichen weder MoO₂ Peaks noch MoO₃ Peaks aufweist.

3. Bauteil nach Anspruch 1, **dadurch gekennzeichnet, dass** die Mo-N-O Schicht zwischen einer Molybdännitridschicht und einer Molybdänmonoxidschicht liegt.

4. Bauteil nach Anspruch 1 oder 3, **dadurch gekennzeichnet, dass** die Mo-N-O Schicht, eine gradierte Schicht ist, wobei die Stickstoffkonzentration von der substratnahen Grenzfläche zur oberflächennahen Grenzfläche der Mo-N-O Schicht abnimmt, während die Sauerstoffkonzentration zunimmt.

5. Bauteil nach Anspruch 1 oder 3, **dadurch gekennzeichnet, dass** die Mo-N-O Schicht, eine gradierte Schicht ist, wobei die Sauerstoffkonzentration von der substratnahen Grenzfläche zur oberflächennahen Grenzfläche der Mo-N-O Schicht abnimmt während die Stickstoffkonzentration zunimmt.

6. Bauteil nach Anspruch 1 oder 3, -**dadurch gekennzeichnet, dass** die Beschichtung mindestens eine Beschichtung nach Anspruch 4 umfasst und mindestens eine Beschichtung nach Anspruch 5 umfasst.

7. Bauteil nach einem der vorherigen Ansprüche, **dadurch gekennzeichnet, dass** die Beschichtung eine Deckschicht mit MoO₃ aufweist.

8. Bauteil nach einem der vorherigen Ansprüche, **dadurch gekennzeichnet, dass** zwischen dem Grundkörper und der Mo-haltigen Schicht mindestens eine Haftschicht und/oder mindestens eine Funktionsschicht abgeschieden ist.

9. Bauteil nach einem der vorherigen Ansprüche, **dadurch gekennzeichnet, dass** mindestens eine Mo-haltige Schicht insbesondere sehr gute mechanische Stabilität aufweist und (Mo₁₋ₓ, Meₓ)AₐB_{b}C_{c} enthält, wobei 0≤ x ≤ 0.99, vorzugsweise 0≤ x ≤ 0.5, und Me ein Metall aus der Gruppe von W, Ti, AI, Cr, Si, Zr, Ta, Nb, Ag, Cu und V ist, oder der Kombination aus zwei oder mehreren Metallen dieser Gruppe und
A: Stickstoff (N) ist mit 0.5≤ a ≤ 1
B: Kohlenstoff (C) ist mit 0≤ b ≤ 0.5
C: Sauerstoff (O) ist mit 0≤ c ≤ 0.5
und mit a, b, und c in at% zwischen den Elementen N, C und O angibt mit a+b+c = 1 und zusätzliche weitere Elemente vorgesehen sein können, aber vorzugsweise nicht vorgesehen sind, und x≥c.

10. Bauteil nach einem der vorherigen Ansprüchen, **dadurch gekennzeichnet, dass** mindestens eine Mo-haltige Schicht insbesondere sehr gute Schmierstoffeigenschaften und Gleiteigenschaften aufweist und (Mo_{1-y,}Me_{y})AᵤBᵥC_{w} enthält, wobei
0≤ y ≤ 0.99, vorzugsweise 0≤ y ≤ 0.5 und
Me ein Metall aus der Gruppe von W, Ti, AI, Cr, Si, Zr, Ta, Nb, Ag, Cu und V ist, oder der Kombination aus zwei oder mehreren Metallen dieser Gruppe und
A: Stickstoff ist mit 0.5≤ u ≤ 1
B: Kohlenstoff ist mit 0≤ v ≤ 0.5
C: Sauerstoff ist mit 0≤ w ≤ 0.5
und mit u, v, und w in at% zwischen den Elementen N, C und O angibt mit u+v+w = 1 und zusätzliche weitere Elemente vorgesehen sein können, aber vorzugsweise nicht vorgesehen sind, und y≥w.

11. Bauteil nach einem der vorherigen Ansprüche, **dadurch gekennzeichnet, dass** die Beschichtung mindestens eine erste Schicht nach Anspruch 9 und eine zweite Schicht nach Anspruch 10 umfasst.

12. PVD Verfahren oder kombiniertes PVD/CVD Verfahren zur Herstellung einer Beschichtung nach einem der vorherigen Ansprüche **dadurch gekennzeichnet, dass** das Molybdänmonoxid in der Molybdänmonoxid umfassenden Schicht mittels Funkenverdampfen abgeschieden wird.

13. PVD Verfahren zur Herstellung einer Beschichtung nach einem der vorherigen Ansprüche, **dadurch gekennzeichnet, dass** die molybdänhaltigen Schichten mittels Funkenverdampfen von mindestens einem molybdänhaltigen Target in Reaktivatmosphäre hergestellt werden.

14. Anwendung eines Werkzeugs beschichtet nach Anspruch 13 zur Fertigung von Bauteilen aus Metallen oder Metalllegierungen, **dadurch gekennzeichnet, dass** durch die Beschichtung Aufschmierungen der bearbeiteten Metalle oder Metalllegierungen auf die beschichtete Oberfläche des Werkzeugs reduziert oder vorzugsweise vollständig vermieden werden.

## Claims

1. Component having a coating comprising at least one layer containing molybdenum with molybdenum oxide, **characterized in that** the molybdenum oxide is essentially molybdenum monoxide and the coating comprises at least one molybdenum nitride layer and the coating comprises at least one Mo-N-O layer including molybdenum-nitrogen compounds and molybdenum-oxide compounds, wherein essentially the molybdenum atoms form a compound with a maximum of one oxygen atom.

2. Component according to claim 1 **characterized in that** the coating comprises at least one molybdenum oxide layer that essentially includes molybdenum monoxide and **in that** the XRD spectrum of the molybdenum monoxide layer essentially exhibits neither MoO₂ peaks nor MoO₃ peaks.

3. Component according to claim 1, **characterized in that** the Mo-N-O layer lies between a molybdenum nitride layer and a molybdenum monoxide layer.

4. Component according to claim 1 or 3, **characterized in that** the Mo-N-O layer is a graded layer, wherein the nitrogen concentration decreases from the boundary surface close to the substrate towards the boundary surface close to the surface of the Mo-N-O layer whilst the oxygen concentration increases.

5. Component according to claim 1 or 3, **characterized in that** the Mo-N-O layer is a graded layer, wherein the oxygen concentration decreases from the boundary surface close to the substrate towards the boundary surface close to the surface of the Mo-N-O layer whilst the nitrogen concentration increases.

6. Component according to claim 1 or 3, **characterized in that** the coating comprises at least one coating according to claim 4 and at least one coating according to claim 5.

7. Component according to one of the preceding claims, **characterized in that** the coating has a cover layer with MoO₃.

8. Component according to one of the preceding claims, **characterized in that** at least one adhesion layer and/or at least one functional layer is deposited between the base body and the layer containing Mo.

9. Component according to one of the preceding claims, **characterized in that** at least one layer containing Mo has in particular very high mechanical stability and contains (Mo₁₋ₓ, Meₓ) AₐB_{b}C_{c}, wherein 0 ≤ x ≤ 0.99, preferably 0 ≤ x ≤ 0.5 and Me is a metal from the group of W, Ti, Al, Cr, Si, Zr, Ta, Nb, Ag, Cu and V or the combination of two or more metals of this group and
A: is nitrogen (N) with 0.5 ≤ a ≤ 1
B: is carbon (C) with 0 ≤ b ≤ 0.5
C: is oxygen (O) with 0 ≤ c ≤ 0.5
and wherein a, b and c indicate in at% between the elements N, C and O with a+b+c=1 and additional further elements can be provided but are preferably not provided, and x ≥ c.

10. Coating according to one of the preceding claims, **characterized in that** at least one layer containing Mo has in particular very good lubricating properties and sliding characteristics and contains (Mo_{1-y}, Mey) AᵤBᵥC_{w}, wherein 0 ≤ y ≤ 0.99, preferably 0 ≤ y ≤ 0.5 and Me is a metal from the group of W, Ti, Al, Cr, Si, Zr, Ta, Nb, Ag, Cu and V or the combination of two-or more metals of this group and
A: is nitrogen with 0.5 ≤ u ≤ 1
B: is carbon with 0 ≤ v ≤ 0.5
C is oxygen (O) with 0 ≤ w ≤ 0.5
and wherein u, v and w indicate in at% between the elements N, C and O with u+v+w=1 and additional further elements can be provided but are preferably not provided, and y ≥ w.

11. Component according to one of the preceding claims, **characterized in that** the coating comprises at least one first layer according to claim 9 and a second layer according to claim 10.

12. PVD process or combined PVD/CVD process for the production of a coating according to one of the preceding claims, **characterized in that** the molybdenum monoxide is deposited in the layer containing molybdenum monoxide by means of spark evaporation.

13. PVD process for the production of a coating according to one of the preceding claims, **characterized in that** the molybdenum-containing layers are produced by means of spark evaporation of at least one target containing molybdenum in a reactive atmosphere.

14. Use of a tool coated according to claim 13 for the production of components of metals or metal alloys, **characterized in that** the coating makes it possible to reduce or preferably completely prevent smearing of the machined metals or metal alloys on the coated surface of the tool.

## Revendications

1. Composant ayant un revêtement comprenant du moins une couche contenant du molybdène avec l'oxyde de molybdène, **caractérisé par le fait que** l'oxyde de molybdène est essentiellement du monoxyde de molybdène et le revêtement comprend du moins une couche de nitrure de molybdène et le revêtement comprend du moins une couche Mo-N-O comprenant des liaisons molybdène-azote et des liaisons molybdène-oxyde, les atomes de molybdène formant essentiellement une liaison avec un atome d'oxygène au maximum.

2. Composant selon la revendication 1 **caracterisé par le fait que** le revêtement comprend du moins une couche d'oxyde de molybdène comprenant essentiellement du monoxyde de molybdène et que le spectre XRD de la couche de monoxyde de molybdène ne comprend essentiellement ni des pics MoO₂ ni des pics MoO₃.

3. Composant selon la revendication 1 **caracterisé par le fait que** la couche Mo-N-O se trouve entre une couche de nitrure de molybdène et une couche de monoxyde de molybdène.

4. Composant selon la revendication 1 ou 3 **caracterisé par le fait que** la couche Mo-N-O est une couche graduée, la concentration d'azote se réduisant de la surface de délimitation proche du substrat à la surface de délimitation proche de la surface de la couche Mo-N-O, tandis que la concentration d'oxygène augmente.

5. Composant selon la revendication 1 ou 3 **caracterisé par le fait que** la couche Mo-N-O est une couche graduée, la concentration d'oxygène se réduisant de la surface de délimitation proche du substrat à la surface de délimitation proche de la surface de la couche Mo-N-O, tandis que la concentration d'azote augmente.

6. Composant selon la revendication 1 ou 3 **caracterisé par le fait que** le revêtement comprend du moins un revêtement selon la revendication 4 et du moins un revêtement selon la revendication 5.

7. Composant selon une des revendications précédentes **caracterisé par le fait que** le revêtement comprend une couche supérieure contenant du MoO₃.

8. Composant selon une des revendications précédentes **caracterisé par le fait que**, entre le corps de base et la couche contenant du Mo du moins une couche adhésive et/ou du moins une couche de fonction est déposée.

9. Composant selon une des revendications précédentes **caracterisé par le fait que** du moins une couche contenant du Mo a particulièrement une très bonne stabilité mécanique et comprend (Mo₁₋ₓ, Meₓ)AₐB_{b}C_{c} avec 0≤x≤0.99, de préférence 0≤x≤0.5 et Me étant un métal du groupe de W, Ti, Al, Cr, Si, Zr, Ta, Nb, Ag, Cu et V, ou une combinaison de deux ou plusieurs métaux de ce groupe et
A: étant de l'azote (N) avec 0.5≤a≤1
B: étant du carbone (C) avec 0≤b≤0.5
C: étant de l'oxygène (O) avec 0≤c≤0.5
et a,b et c indiquant en pourcentage atomique (at%) entre les éléments N, C et O avec a+b+c=1 et d'autres éléments supplémentaires peuvent être prévus, mais de préférence ne sont pas prévus, et x≥c.

10. Composant selon une des revendications précédentes **caracterisé par le fait que** du moins une couche contenant du Mo présente en particulier de très bonnes caractéristiques lubrifiantes et caractéristiques coulissantes et comprend (Mo_{1-y}, Me_{y})AᵤBᵥC_{w}, avec
0≤y≤0.99, de préférence 0≤y≤0.5 et
Me étant un métal du groupe de W, Ti, Al, Cr, Si, Zr, Ta, Nb, Ag, Cu et V, ou une combinaison de deux ou plusieurs métaux de ce groupe et
A: étant de l'azote avec 0.5≤u≤1
B: étant du carbone avec 0≤v≤0.5
C: étant de l'oxygène avec 0≤w≤0.5
et u, v et w indiquant en pourcentage atomique (at%) entre les éléments N, C et O avec u+v+w=1 et d'autres éléments supplémentaires peuvent être prévus,
mais de préférence ne sont pas prévus, et y≥w.

11. Composant selon une des revendications précédentes **caracterisé par le fait que** le revêtement comprend du moins une- première couche selon la revendication 9 et une seconde couche selon la revendication 10.

12. Procédé PVD ou procédé combiné de PVD et CVD de production d'un revêtement selon une des revendications précédentes **caractérisé par le fait que** le monoxyde de molybdène est déposé dans la couche contenant du monoxyde de molybdène au moyen de vaporisation d'étincelles.

13. Procédé PVD de production d'un revêtement selon une des revendications précédentes **caractérisé par le fait que** les couches contenant du molybdène sont produites au moyen de vaporisation d'étincelles de du moins une cible contenant du molybdène dans une atmosphère réactive.

14. Application d'un outil revêtu selon la revendication 13 pour produire des composants de métaux ou d'alliages métalliques **caractérisé par le fait que** des lubrifications des métaux usinés ou des alliages métalliques usinés sur la surface revêtue de l'outil peuvent être réduites ou de préférence complètement évitées par le revêtement.
